# EUROPEAN PATENT SPECIFICATION

(11) **EP 4 679 072 B1**
(45) Date of publication and mention of the grant of the patent: **14.10.2026**
(21) Application number: 25187984.7
(22) Date of filing: 07.07.2025
(51) Int. Cl.: G01N 27/07, G01N 27/416, G01N 33/00

(54) **ELECTROCHEMICAL MIGRATION TESTING DEVICE**
ELEKTROCHEMISCHE MIGRATIONSTESTVORRICHTUNG
DISPOSITIF DE TEST DE MIGRATION ÉLECTROCHIMIQUE

(30) Priority: 08.07.2024 CZ 20240275; 22.05.2025 CZ 202542858 U
(43) Date of publication of application: 14.01.2026
(73) Proprietor: Ceske vysoke uceni technicke v Praze, 160 00 Praha 6 - Dejvice (CZ)
(72) Inventor: DUSEK, Karel, 29001 Podebrady (CZ); VESELY, Petr, 27201 Kladno (CZ); KLIMTOVA, Marketa, 25229 Dobrichovice (CZ); KRALOVA, Iva, 19800 Praha 9 (CZ); FROS, Denis, 53003 Pardubice (CZ); BUSEK, David, 19016 Ujezd nad Lesy (CZ)
(74) Representative: Kratochvil, Vaclav

(56) References cited:
- CN-A- 109 581 058
- CN-A- 113 218 857
- CN-A- 116 337 976
- CN-U- 213 286 891

## Description

### Technical field

The presented solution describes a device that enables a new method of testing electrochemical migration, hereinafter referred to as ECM, especially in the field of the electrical industry. The device is intended primarily for testing the suitability of the used material combinations in order to determine their susceptibility to electrochemical migration and dendritic growth. Electrochemical migration tests are among the basic tests performed to verify the reliability of the device.

### State of the art

Electrochemical migration is a well-known phenomenon that occurs on a substrate between two electrodes in the presence of an electrolyte and an electric, usually DC, field between them. This phenomenon is usually observed on printed circuit boards. Many methods exist for electrochemical migration testing. All methods have one thing in common, namely the formation of an electrolyte between the electrodes. The formation of the electrolyte that is carried out by direct deposition of a liquid between the electrodes is called water drop test. Another option is to place the substrate with electrodes in an environment with increased humidity, such as climatic chambers or humidity boxes, where an electrolytic layer is formed by condensation of moisture on the surface of the substrate. Last but not least, this involves placing the substrate with electrodes on a cold body with a temperature lower than the dew point temperature, when condensation of ambient moisture occurs on the substrate, including the space between the electrodes. If there is an electric potential between the electrodes, the basic conditions enabling electrochemical migration are met. The devices are then supplemented with the possibility of monitoring electrochemical migration using electrical or optical methods.

Document CN113376239A "Electrochemical migration test method and device for power packing" describes a method for testing electrochemical migration (ECM) which allows easy in-situ observation of ECM in the Thin electrolyte layer test, referred to as TEL, along with monitoring and recording changes in voltage and current in real time.

The method consists of the following steps.

The first step is to describe the printing of the tested conductive pattern on the substrate using conductive ink. The preferred ink parameters along with the recommended manufacturing process are described in detail in the patent. This is followed by surface treatment using plasma and subsequent fixation with high-temperature tape of a certain area of the square surface so that a liquid film with the same thickness and area can be formed there. The last step is the observation of the ECM, where the sample is placed in the measuring station, an optical microscope is set to observe the sample and a power meter is connected to the electrodes of the tested sample. Then, liquid is dropped onto the sample so that the desired liquid film is formed and only then is a voltage applied.

The method is fast, easy to operate, simple to prepare, and ECM is easily observable. There is a precisely controlled contact area between the sample and the electrolyte, which can increase the accuracy of quantitative analysis of the ECM process and its repeatability.

In this method, the sample is placed on a support under an optical microscope/optical camera and is connected to a voltage source. The test area of the sample is surrounded by high-temperature tape so that a defined layer of test liquid is maintained within the area. The voltage source is connected to a device that monitors voltage and current.

The disadvantage of the described solution is that it describes a method that does not include the condensation of the electrolytic layer, which is an important influencing factor of the ECM, and therefore does not monitor the overall real behavior of the ECM. The test cannot be used for certain analyses where condensation can play a significant role.

Furthermore, a solution according to CN103344691A is known, entitled "Water-drop system for electrochemical migration experiment". The station consists of a computer unit, a motor drive, a stepper motor, a dripping device, a video recording device, an insulation resistance measuring device, a pressure sensor, and a pad for the tested sample. The computer unit is connected to the pressure sensor, the video recording device and the insulation resistance measuring device, from which it collects data. The driving mechanism controls a stepper motor, which is connected to the pad and can therefore change the position of the pad in a horizontal position. Movements of the dripping device are recorded on video. There is a pressure sensor on the pad, on which the tested sample is placed. The dripping device consists of another stepper motor, a connecting rod, a piston and a dripper, where the computer-controlled stepper motor moves the rod connecting the motor and the piston. By moving the piston, a defined amount of liquid is then applied to the sample through the dripper.

The advantage of this setup is automatic control of water dripping and its quantity, which prevents errors caused by manual manipulation in a classic water drop test. At the same time, the use of triaxial and shielded cables reduces interference and test noise, and can also increase the accuracy of insulation resistance measurements.

The disadvantage of this solution is that it does not include the condensation of the electrolyte layer, which is an important influencing factor of the ECM, and therefore does not track the overall real-world behavior of the ECM. Therefore, the test cannot be used for certain analyses where condensation can play a significant role.

Another solution according to GB2557439 entitled "Apparatus and method relating to electrochemical migration" is used. This document includes a measurement method, equipment, system and computer software related to electrochemical migration. It describes a method of testing an electrical circuit, where the circuit is thermally connected to a thermal reservoir and stored inside a test chamber. In the test chamber, its temperature is controlled and measured so that condensation occurs on the surface of the circuit during the test. At the same time, electrical parameters inside the chamber are monitored. Condensation is caused by the temperature difference between the electrical circuit and the test chamber, where the temperature of the circuit in the chamber must reach the dew point or lower at least once. The chamber temperature is given by a selected temperature profile, which allows the test to be repeated. An example of a temperature profile is, for example, gradual heating with a temperature increase of 1 °C per minute, when the desired temperature is reached, setting a constant temperature in the chamber for a selected time and then cooling the chamber again with a temperature decrease of 1 °C per minute. Humidity can also be controlled in the chamber to promote condensation on the circuit surface.

The device consists of a test chamber connected to an external device for controlling the temperature and humidity parameters inside the chamber. Inside the chamber, there is a tested sample placed on a heating device that affects the temperature of the tested sample. The tested sample is connected to a device for monitoring the electrical parameters of the sample, which is located outside the chamber. The monitoring and control devices for the internal parameters in the chamber are connected to a common control device.

The disadvantage is that precise control of temperature and humidity parameters can be difficult and expensive. The test equipment also does not include optical equipment for observing ECM.

Another well-known document is CN113218857A entitled "Electrochemical analysis device and method for electrochemical migration of electronic product". It describes a method for monitoring electrochemical migration, which allows precise application of liquid drops in terms of volume, position, weight, and at the same time allows exposure of the sample to an environment where it is possible to influence multiple factors such as temperature, humidity and ambient gases. The workplace consists of a closed container, which is connected to an air circulation system, polluted and waste gas systems and a control panel. Inside the container there is a movable, lifting, pad, above which a rotating head is attached to the ceiling of the container. A test device consists of a microsyringe, an electrochemical probe with two electrodes, a reference and, auxiliary, and a microscope is attached to the lower part of the rotating head. The probe is connected to a station with a voltage source and a computer. Before the actual testing, the sample is mounted on a movable base and the given solution is applied drop by drop using a microsyringe, while everything is controlled on the control panel. Then the electrochemical probe is adjusted so that its lower part is in contact with the droplets on the plate. According to the requirements of the surrounding environment, it is possible to bring the desired gas into the container and set the ambient temperature and humidity. After setting the conditions, voltage is applied to the sample. The measurement can take 1-24 hours, while the obtained data is saved to the computer.

The disadvantage of the above solution is that it describes a method that does not include the condensation of the electrolyte layer, which is an important influencing factor of the ECM, and therefore does not monitor the overall real-world behavior of the ECM. The test cannot be used for certain analyses where condensation can play a significant role.

Another well-known document is JP2011153886A entitled "Method for evaluating electrochemical migration, and evaluation system". The aim of the method is to evaluate electrochemical migration that occurred between electrodes. The method is based on calculating impedance using an equivalent electrical circuit describing the movement of charge between the anode and cathode using resistances and capacitances. The entire system consists of a closed container in which the temperature and humidity can be controlled, a tested sample is placed in it, connected to a voltage source and a device for measuring current and calculating impedance from the obtained data. Finally, an optical device is placed above the tested sample to monitor the electrochemical migration process. The patent application was rejected because it is a publicly used method that can be easily performed with basic knowledge of the issue.

Document CN1124622146A, "Salt droplet detection method for detecting capability of electrode materials in resisting failures caused by electrochemical migration" is also known. It describes a test method commonly known as the Water Drop Test (WDT). In this case, the method is used to compare different electrode materials and assess their ability to resist electrochemical migration caused by soluble salt contamination. A solution of NaCl or Na2SO4 with a defined concentration is used as the electrolyte. Before testing, the sample must first be cleaned and then dried. It is then connected to a picoammeter. After dripping the solution onto the tested electrodes so that the drops completely cover their surface, voltage is applied. The insulation resistance is measured at 1-second intervals until the resistance value drops to 50 kΩ, and after 120 seconds, the measurement is ended. During the measurement, the electrochemical migration process can also be observed under an optical microscope.

The device consists of a classic water drop test setup. Above the tested sample there is an optical microscope that observes the tested sample and transmits the image to a computer. The tested sample is connected to a measuring device that serves as a voltage source and at the same time senses changes in the electrical parameters of the sample. The measuring device is controlled by a computer.

WDT is a well-known method of ECM testing ECM. However, the condensation phase is omitted in the test. Therefore, the test cannot be used for certain analyses where the formation of an electrolytic layer by condensation can play a significant role.

A disadvantage of all these solutions is that drops may form on the upper cover of the test chamber in which the tested sample is placed, which may subsequently accidentally drip onto the sample and thus negatively affect the accuracy of testing.

### Summary of invention

The above-mentioned disadvantages and shortcomings are eliminated by the device for testing electrochemical migration according to the present invention as described in the claims. The solution comprises a test chamber for placing the tested sample and test liquid. The essence of the new solution is that the test liquid is placed directly inside the bottom of the test chamber, which can be closed with a lid. A controllable heating device is placed near the test liquid for its heating. Above the level of the test liquid, a height- and angle-adjustable carrier for the tested sample is located in the test chamber. The device is equipped with a power cable for connecting the tested sample to a voltage source.

In one possible embodiment, the heating device is connected bidirectionally, either directly or via a temperature controller, to a control and evaluation unit equipped with software for monitoring and evaluating temperature and humidity parameters. This control and evaluation unit is connected bidirectionally to the measuring device. The voltage source is connected bidirectionally to the control and evaluation unit. The device is equipped with at least one test liquid temperature sensor and/or at least one temperature sensor on the tested sample and/or at least one temperature and humidity sensor in the test chamber. The cable for connecting the measuring device to the tested sample, as well as the cables connected bidirectionally to the control and evaluation unit, namely the cable from the temperature and humidity sensor in the test chamber, the cable from the temperature sensor on the tested sample, and the cable from the test liquid temperature sensor, are led out of the test chamber through at least one feedthrough. The test chamber is equipped with a closable opening for inserting and removing the tested sample.

The passageway or passages and the opening for inserting and removing the tested sample are preferably hermetically sealed. The opening for inserting and removing the tested sample is formed in the lid or in the body of the test chamber. As for the passages, at least one feedthrough is formed in the lid and/or in the body of the test chamber.

For observing electrochemical migration, it is advantageous if an optical device is placed in the field of view of the tested sample, which is led out of the test chamber by a cable connected bidirectionally to the control and evaluation unit.

In one convenient design, a stand is placed at the bottom of the test chamber. The stand has three parts, the first stand with a height- and angle-adjustable arm for placing the temperature and humidity sensor of the test chamber space, the second stand with a height- and angle-adjustable arm for placing the temperature sensor of the test liquid immersed in the test liquid, and the third stand with a height- and angle-adjustable arm for placing the optical device. The carrier for fixing the tested sample in this case consists of a height- and angle-adjustable fourth arm on the first stand, on which the tested sample with the temperature sensor on the tested sample is attached.

As for the test liquid used, it is from the group according to the selected test parameters, either distilled water, Na₂SO₄ solution or NaCl solution.

Another improvement is that the deflector is placed in the space above the test sample, the area of which is larger than the area of the test sample. This deflector prevents accidental dripping of condensed water onto the test sample during the test, thereby significantly increasing the reliability and repeatability of this method.

In one possible embodiment, the deflector has an inclination in the range of 3° to 80° with respect to the level of the test liquid (4).

The deflector thus realized can be created in several ways.

One of them is that it is formed directly by the sealable lid of the test chamber.

Another variant is an auxiliary plane, which is placed between the sealable lid of the test chamber and the test sample. In this case, the auxiliary plane can be attached by its ends to the inner shell of the test chamber, for example, or it can be suspended on cables in the test chamber.

Another variant is an arrangement following the example, where the test sample is placed in the test chamber on the first stand on a height and angle adjustable fourth arm and the auxiliary plane is placed between the upper lid and the test sample on the auxiliary arm. A modification of this embodiment is that the auxiliary plane is placed on a separate stand.

In all of these examples, it is advantageous if the auxiliary plane is height and angle adjustable.

To better prevent accidental dripping of liquid, it is appropriate to provide the upper lid or the auxiliary plane with a hydrophilic textile, which is fixed from the underside of the upper lid or the auxiliary plane facing the test sample.

In the second possible embodiment, the deflector is provided with a heating element.

Here again, the deflector can be formed directly by the upper lid of the test chamber or by an auxiliary plane placed between the upper lid of the test chamber and the tested sample. The possibilities of placing the auxiliary plane in the space of the test chamber above the tested sample are the same as in the cases of the first embodiment, when the auxiliary plane is attached by its ends to the inner shell of the test chamber, suspended on cables or placed on an auxiliary arm on the stand, where the tested element is placed or on a separate stand.

It is also possible to have an embodiment where the auxiliary plane with the heating element is height and angle adjustable.

The proposed device retains the advantages of known ECM testing methods and reduces their disadvantages. Unlike testing using WDT, it includes a condensation phase, so the test conditions correspond to real conditions for the formation of ECM. Compared to ECM testing using climate chambers, it significantly reduces testing time and at the same time reduces economic costs.

Existing ECM testing methods either neglect the condensation phase in ECM testing or are difficult to implement because they require specialized equipment. The new device provides rapid testing, where the presence of the test liquid in the heated test chamber causes the test liquid to condense on the tested sample, which is placed above the test liquid. Placing the test liquid in the same test chamber and directly below the tested sample has not been implemented anywhere yet. The device allows for faster equilibrium. It is a cheaper and simpler solution that does not require any circulation system or external container with test liquid to create humidity in the test chamber.

The advantage of the solution with a deflector is that this deflector, placed above the test sample, prevents accidental dripping of liquid from the upper lid of the chamber onto the test sample. Thanks to this, the accuracy of the tests performed is not affected. The deflector can be designed with a tilt in the range from 3° to 80°, in which case the condensing liquid drips outside the test sample. Or the deflector can be designed with heating, in which case moisture condensation does not occur on the deflector and the test sample is also protected from accidental dripping. Alternatively, a combination of both methods can be used. The area of the deflector is larger than the area of the test sample.

### Brief description of drawings

The electrochemical migration testing device according to the present invention is described in more detail on a specific example of embodiment with the help of the attached drawings. Fig. 1 shows a block diagram of the entire device. Fig. 2 and Fig. 3 present examples of the placement of individual elements in the test chamber. Fig. 4 shows an example where the chamber is equipped with a deflector, which is directly formed by the upper lid of the test chamber. Figs. 5, 6, and 7 show examples where the deflector is formed by an auxiliary plane.

### Examples of implementation of the invention

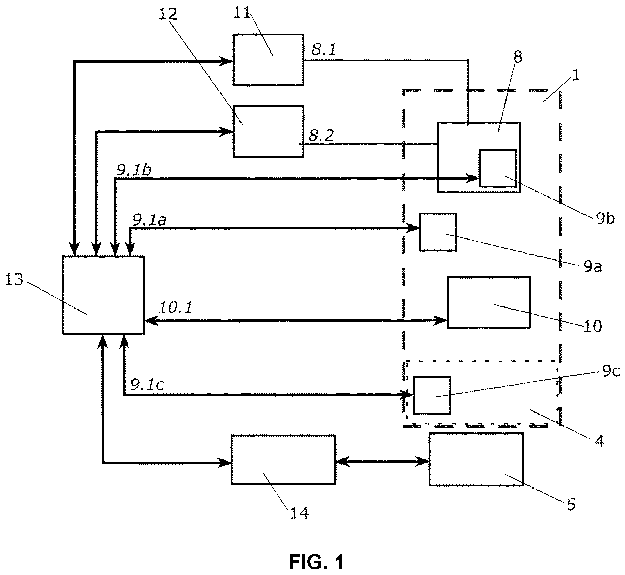

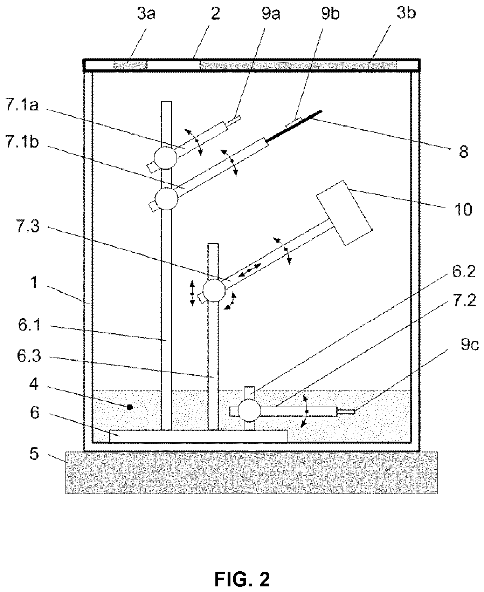

One example of an embodiment of a device for testing electrochemical migration is shown in Fig. 1 and Fig. 2. The device here includes a test chamber 1 with a test liquid 4, sensors for monitoring temperature and humidity parameters in the test chamber 1 and on the tested sample 8, a voltage source 11 for powering the tested sample 8, a controllable heating device 5, a measuring device 12 and a control and evaluation unit 13. As for the sensors, their type and number may vary. This control and evaluation unit 13 is equipped with software for monitoring temperature and humidity parameters, monitoring changes in the properties of the tested sample 8 and their evaluation. As for the sensors, a sensor 9a is used for sensing temperature and humidity in the space of the test chamber 1, a sensor 9b for sensing temperature on the tested sample 8 and a sensor 9c for monitoring the temperature of the test liquid 4. At the bottom of the test chamber 1 hermetically sealed by a lid 2 is the test liquid 4. Near the space with the test liquid 4, a heating device 5 is located, which is connected bidirectionally, either directly, or in this example via a temperature controller 14, with control and evaluation unit 13. A sensor 9c is located in the test liquid 4 for monitoring the temperature of the test liquid 4. Above the level of the test liquid 4, a carrier for fixing the tested sample 8 is located in the test chamber 1, which is equipped with a sensor 9b for sensing the temperature on the tested sample 8. Furthermore, a sensor 9a is located in the test chamber 1 for sensing the temperature and humidity in the test chamber 1. The volume of the test liquid 4 is selected in particular depending on the type of test liquid used, the size of the test chamber 1 and the required parameters of the test performed to achieve an equilibrium state in the test chamber 1. The device further includes a power cable 8.1 for connecting a voltage source 11 to the tested sample 8, where this voltage source is bidirectionally connected to the control and evaluation unit 13. Another cable is a cable 8.2 for connecting the measuring device 12 to the tested sample 8. The measuring device is bidirectionally connected to the control and evaluation unit 13. The device also includes cables connected bidirectionally to the control and evaluation unit 13, namely cable 9.1a from sensor 9a temperature and humidity in the test chamber 1, cable 9.1b from the temperature sensor 9b on the tested sample 8 and cable 9.1c from the temperature sensor 9c of the test liquid 4. All these cables are led out of the test chamber 1 through at least one bushing 3a . The test chamber 1 is also provided with a closable opening 3b for inserting and removing the tested sample 8. This entire assembly is hermetically sealed to prevent leakage of the test liquid 4, which is located inside the test chamber 1, during the tests.

The lid 2 is realized in such a way that it can be easily manipulated, that is, opening the test chamber 1 to remove/insert the tested sample 8. At the same time, it is important to achieve the greatest possible hermeticity when the test chamber 1 is closed, in order to prevent leakage of the test liquid during the measurement.

The feedthrough 3a can be implemented as a single hole or as multiple holes. Depending on the specific needs and arrangement of the measuring system, the feedthroughs 3a can be located in the lid 2 or in the wall of the test chamber 1, or in both places.

The opening 3b for inserting and removing the tested sample 8 may be formed in the lid 2 or in the body of the test chamber 1. As for the feedthroughs 3a, they may all be in the lid 2 or all in the body of the test chamber 1 or some in the lid 2 and some in the body of the test chamber 1.

For optical monitoring of the electrochemical migration process and data collection, it is possible to place an optical device 10 in the test chamber 1, in the field of view of the tested sample 8. This optical device 10 is led out of the test chamber 1 by an optical device cable 10.1 bidirectionally connected to the control and evaluation unit 13. The optical device 10 is understood to be any optical device suitable for the given conditions inside the test chamber 1, for example with IP X5 certification and higher, which allows observation of electrochemical migration on the tested sample 8. A suitable possible solution is an optical microscope camera allowing video recording/images of the testing and at the same time some detailed zooming of the monitored image.

Measuring device 12 is an instrument for measuring electrical quantities. An ammeter can be used for direct measurement of the current passing through the tested sample 8, a voltmeter for measuring the voltage drop across a suitably selected resistance shunt, or an ohmmeter, i.e. an insulation resistance meter, in which case this device is the source of the test voltage. An electrical short circuit on the tested sample 8 caused by electrochemical migration is detected by a sharp change in the measured quantity, ^{~}tens of %/s.

By test liquid 4 is meant distilled water, which is used as a standard medium for testing using WDT or in climate chambers. However, other types of liquids can be used according to requirements. For example, Na₂SO₄ solution can be used to simulate a heavily polluted environment, NaCl solution can be used to simulate a marine climate, and so on. If a test liquid other than distilled water is used, careful cleaning of the test chamber 1 is required when changing the test liquid to avoid contamination.

The heating device 5 is used for controlled heating of the test liquid 4. It is possible to imagine a heating device 5 that creates a constant temperature and will heat the liquid to a fixed temperature. In practice, however, it will usually be a controllable heating device 5, whose implementations may be different. The heating device 5 may be implemented by a heating surface under the test chamber 1, as shown in Fig. 1, with the heating of the surface controlled by a controller 14. For example, a heating element may be used to heat the test liquid 4, which will be inserted directly into the test liquid 4. However, this heating element must not contaminate the test liquid 4.

As regards the arrangement of the sensors 9a, 9b and 9c and the location of the tested sample 8 inside the test chamber 1, two examples of arrangements are given here.

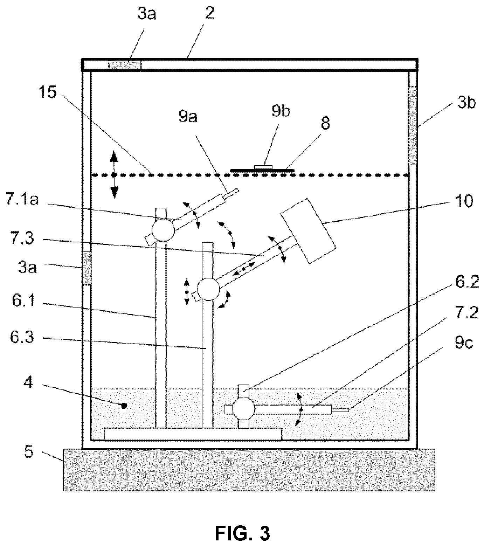

It is also possible to implement a simplified embodiment according to Fig. 3, where a stand 6 is again placed at the bottom of the test chamber 1, provided with a first sub-stand 6.1 with a height- and angle-adjustable first arm 7.1a for placing a sensor 9a of the temperature and humidity of the test chamber 1. A second sub-stand 6.2 is further formed on the stand 6 with a height- and angle-adjustable second arm 7.2 for placing a sensor 9c of the temperature of the test liquid 4. This second arm 7.2 is immersed in the test liquid 4. A third sub-stand 6.3 is also implemented on the stand 6 with a height- and angle-adjustable third arm 7.3 for placing an optical device 10. In this example, the carrier for fixing the tested sample 8 is formed by a grid 15 suspended in the test chamber 1, which is preferably height-adjustable.

One specific example of a device design is shown in Fig. 2. A stand 6 is placed at the bottom of the test chamber 1. The stand 6 has a first sub-stand 6.1 with a height- and angle-adjustable first arm 7.1a for placing the temperature and humidity sensor 9a of the test chamber 1, a second sub-stand 6.2 immersed in the test liquid 4 with a height- and angle-adjustable second arm 7.2 for placing the temperature sensor 9c of the test liquid 4, and a third sub-stand 6.3 with a height- and angle-adjustable third arm 7.3 for placing the optical device 10. In this example, the carrier for fixing the tested sample 8 is formed by a height- and angle-adjustable fourth arm 7.1b formed on the first sub-stand 6.1, on which the tested sample 8 and the temperature sensor 9b on the tested sample 8 are mounted.

The aim is to implement a device enabling the evaluation of the electrochemical migration phenomenon that occurs between electrodes with different electrical potentials. The essence is to create conditions for the condensation of the electrolytic layer and an electric field for electrochemical migration, but in a different way than in known devices. These conditions are created on the test sample 8, which is placed together with the test liquid 4 in the test chamber 1. Completely new and crucial is that the tested sample 8 is placed above the test liquid 4, which is heated to such a temperature that its evaporation occurs, and thus the equilibrium level of relative humidity is created quickly. Moisture condensation occurs on the tested sample 8, which creates one of the main conditions for monitoring electrochemical migration. The tested sample 8 is connected to a voltage source 11 and a measuring device 12 used to monitor the electrical parameters on the tested sample 8. Sensors for monitoring temperature and humidity are located in the test chamber 1, in the test liquid 4, in the space above the test liquid 4 and on the tested sample 8. The tested sample 8, or rather the electrochemical migration process, can also be visually observed. Sensors 9a, 9b and 9c, voltage source 11, measuring device 12 and a microscope-camera implementing the optical device 10 are connected to a control and evaluation unit 13. The electrochemical migration is evaluated based on data recording from the measuring device 12, when changes in the electrical parameters of the tested sample 8 are evaluated.

In the simplest basic design without sensors 9a, 9b and 9c, without measuring device 12 and without control and evaluation unit 13, it is possible to evaluate the test visually, where in test chamber 1 there will be a heated test liquid 4, which will condense on the tested sample 8 connected to a voltage source 11.

The procedure with the new device is as follows. Before the test itself, it is necessary to prepare the individual parts inside the test chamber 1 containing the test liquid 4. The position of the tested sample 8 carrier, i.e. the grid 15 or according to the second example the fourth arm 7.1b, holding the tested sample 8 is set according to the test parameters and the required tilt angle and height of the tested sample 8 are selected. The position of the third arm 7.3 carrying the optical device 10 is set so that the focused tested sample 8 is observed using an optical device 10. The tested sample 8 can be inserted into the test chamber 1 right at the beginning of the test. The test chamber 1 starts to heat up and when the required test conditions are met, i.e. when water condenses on the tested sample 8, an electrical voltage is connected to the tested sample 8. The second option is that the test chamber 1 is closed with a lid 2 without the tested sample 8 inserted. The test liquid 4 begins to heat up in the test chamber 1. When the desired temperature of the test liquid 4 and the relative humidity inside the test chamber 1 are reached, depending on the test parameters, the tested sample 8 is inserted through the insertion opening 3b into the test chamber 1, which is then hermetically sealed again. In other words, once the test liquid 4 reaches the desired temperature, the temperature is maintained to ensure even evaporation to achieve the desired relative humidity. After the conditions stabilisation in the test chamber 1, again, depending on the test parameters, the control and evaluation unit 13 sends a command to connect the voltage to the tested sample 8 and to collect data of the electrical parameters. Inside the test chamber 1, an electrolytic layer is formed on the tested sample 8 by condensation of the test liquid 4. The test continues until an electrical short circuit occurs on the tested sample 8. During the test, data is recorded from the sensors 9a, 9b and 9c, the measuring device 12 and the optical device 10. An electrical short circuit is detected by a sudden change in the measured electrical quantity and secondarily optically by means of optical device 10. The test is then terminated. The time to failure from the moment the voltage is applied to the tested sample 8 to the electrical short circuit is determined from the data record.

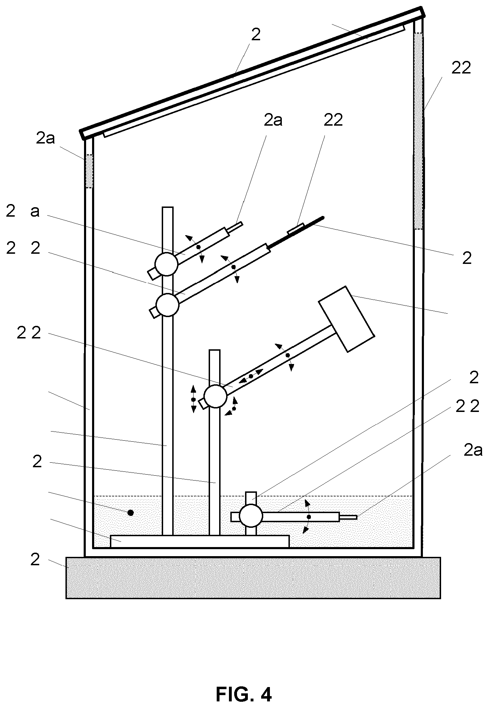

One specific example of the device, where the test chamber 1 is equipped with a deflector, is shown in Fig. 4. The test chamber 1 is hermetically sealed with a closing lid 2, and at its bottom is the test liquid 4. Near the area with the test liquid 4, there is a heating equipment 5. At the bottom of the test chamber 1, there is a stand 6. The stand 6 has a first sub-stand 6.1 with a height and angle adjustable first arm 7.1a for placing the temperature and humidity sensor 9a in the test chamber 1, a second sub-stand 6.2 immersed in the test liquid 4 with a height and angle adjustable second arm 7.2 for placing the testing liquid temperature sensor 9c, and a third sub-stand 6.3 with a height and angle adjustable third arm 7.3 for placing the optical device 10. In this example, the carrier for fixing the tested sample 8 is formed by a height and angle adjustable fourth arm 7.1b created on the first sub-stand 6.1, on which the tested sample 8 and the temperature sensor 9b on the tested sample 8 are attached. The deflector is directly formed by the lid 2, which has an inclination ranging from 3° to 80° and is equipped with a hydrophilic fabric 17, which is fixed to its underside.

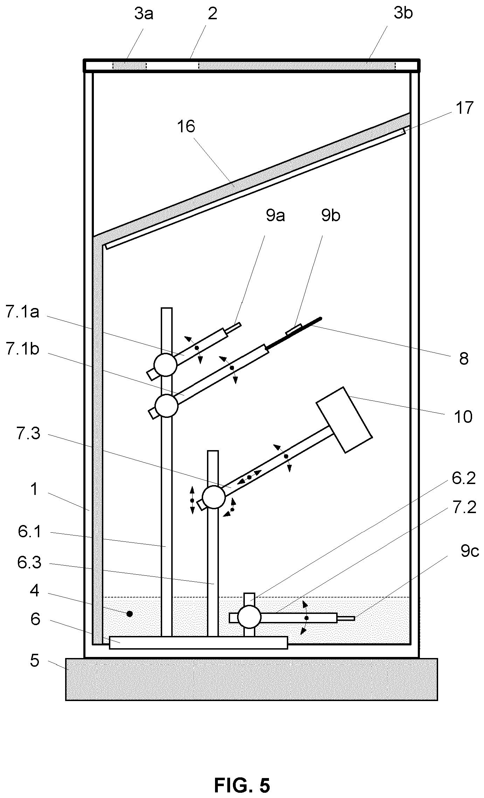

In Fig. 5, a similar test chamber 1 is shown, with the difference being in the placement of the deflector. Here, the deflector is formed by an auxiliary inclined plane 16, which is attached between the side walls of the inner shell of the test chamber 1 and its bottom. The auxiliary plane 16 is also equipped with the hydrophilic fabric 17 on its underside towards the tested sample 8.

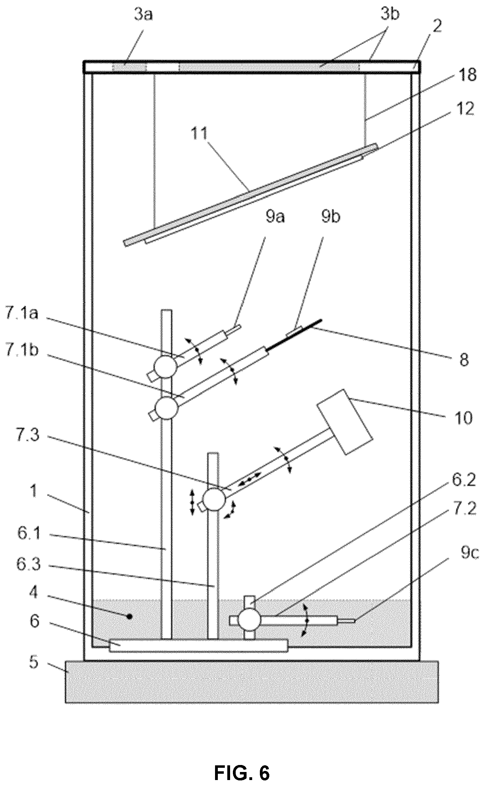

In Fig. 6, a similar solution is shown, based on the arrangement of the test chamber 1 from Fig. 5. The difference is in the method of fixing the deflector, which in this case is attached above the tested sample 8 using cables 18.

The attachment of the auxiliary plane 16 in both cases can be designed to allow for the adjustment of its inclination and distance from the tested sample 8.

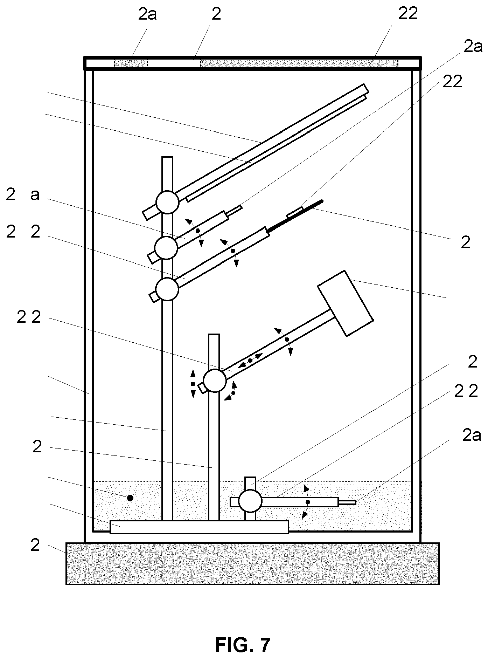

The design according to Fig. 7 is also based on the arrangement of the test chamber 1 from Fig. 1. The deflector is again formed by an auxiliary plane 16, which is placed at the upper end of the first sub-stand 6.1 on a height and angle adjustable auxiliary arm. Here too, the hydrophilic fabric 17 is shown fixed to the underside of the auxiliary inclined plane 16. An alternative is that the auxiliary plane 16 can be placed on a separate leg.

All the above designs can be implemented with a deflector equipped with a heating element such as a heating coil. However, it is not a condition that the deflector be inclined, although in an advantageous design it can be, to completely eliminate any possible dripping of liquid onto the tested sample 8.

In all cases, the condition is always met that the area of the deflector is larger than the area of the tested sample 8. As for the shape, it can be any, but most often it will be a plate. As for the material of the deflector, its properties are chosen depending on the test liquid 4 used so that it does not corrode and the best possible drainage of the liquid away from the tested sample 8 is achieved.

The function of the deflector is the same in all cases, the goal is to prevent accidental dripping of liquid onto the tested sample.

In the design of the deflector formed by an inclined plane, moisture condenses on the deflector and the condensed liquid subsequently drips outside the area under which the tested sample 8 is located. The hydrophilic fabric 17, which can be on the underside of the deflector, helps to better drain the condensed liquid from the surface of the deflector and better protects the tested sample 8 from accidental dripping. In the design of the deflector with a heating element, due to the increased temperature on the deflector, condensation of the liquid will not occur, and thus accidental dripping of the liquid onto the tested sample 8 will not occur.

### Industrial applicability

The device for testing the phenomenon of electrochemical migration is particularly useful in areas where it is necessary to test the susceptibility of used material combinations to electrochemical migration. This involves testing the reliability of printed circuit boards, especially with regard to the climatic conditions in which the given electrical equipment is to be used.

### List of figure tags

- 1: test chamber
- 2: closing lid/cover
- 3a: feedthrough
- 3b: closable opening for inserting and removing the tested sample
- 4: test liquid
- 5: heating equipment
- 6: stand
- 6.1: first sub-stand
- 6.2: second sub-stand
- 6.3: third sub-stand
- 7.1a: first arm
- 7.1b: fourth arm
- 7.2: second arm
- 7.3: third arm
- 8: tested sample
- 8.1: power cable
- 8.2: cable between measuring device and tested sample
- 9a: temperature and humidity sensor in the test chamber
- 9b: temperature sensor on the tested sample
- 9c: testing liquid temperature sensor
- 9.1a: cable from sensor 9a
- 9.1b: cable from sensor 9b
- 9.1c: cable from sensor 9c
- 10: optical device
- 10.1: optical device cable
- 11: voltage source
- 12: measuring device
- 13: control and evaluation unit
- 14: temperature controller
- 15: grid
- 16: auxiliary plane
- 17: hydrophilic fabric
- 18: cables

## Claims

1. An electrochemical migration testing device comprising
- a test chamber (1) for housing a tested sample (8) and
- a test liquid (4), wherein
the test liquid (4) is disposed internally at the bottom of the test chamber (1), wherein
the test chamber (1) is closable by a sealable lid (2),
the device being provided with a power cable (8.1) for connecting the tested sample (8) to a voltage source (11),
**characterized in that**
a controllable heating device (5) is placed in the test chamber's (1) vicinity for its heating, and
a height and angle adjustable tested sample (8) carrier is placed above the level of the test liquid (4) in a test chamber (1) environment.

2. Device according to claim 1, **characterized in that** the controllable heating device (5) is connected bi-directionally, directly or via a temperature controller (14), to a control and evaluation unit (13) equipped with software for monitoring and evaluating temperature and humidity parameters, which is bi-directionally connected to a measuring device (12), and wherein the voltage source (11) is bi-directionally connected to the control and evaluation unit (13), the device being provided with at least one sensor (9c) for temperature of the test liquid (4) and/or at least one sensor (9b) for temperature on the tested sample (8) and/or at least one sensor (9a) for temperature and humidity of the test chamber (1) environment, wherein a cable (8.2) for connecting the measuring device (12) to the tested sample (8), as well as cables connected bi-directionally to the control and evaluation unit (13), namely a cable (9.1a) from the sensor (9a) for temperature and humidity in the test chamber (1) environment, a cable (9.1b) from the sensor (9b) for temperature on the tested sample (8) and a cable (9.1c) from the sensor (9c) for temperature of the test liquid (4) are led out of the test chamber (1) through at least one feedthrough (3a), and the test chamber (1) is provided with a closable opening (3b) for inserting and removing the tested sample (8).

3. Device according to claim 2, **characterized in that** the feedthrough (3a) and the closable opening (3b) for inserting and removing of the tested sample (8) are hermetically sealed.

4. Device according to claim 2 or 3, **characterized in that** the closable opening (3b) for inserting and removing of the tested sample (8) is formed in the sealable lid (2) and/or is formed in the body of the test chamber (1).

5. Device according to any one of claims 2 to 4, **characterized in that** at least one feedthrough (3a) is formed in the sealable lid (2) and/or in a body of the test chamber (1).

6. Device according to any one of claims 1 to 5, **characterized in that** an optical device (10) is positioned in the field of view of the tested sample (8) and is led out of the test chamber (1) by an optical device cable (10.1) bi-directionally connected to the control and evaluation unit (13).

7. Device according to any one of claims 1 to 6, **characterized in that** a stand (6) is located at a bottom of the test chamber (1), equipped with a first sub-stand (6.1) with a height- and angle-adjustable first arm (7.1a) for positioning the sensor (9a) for temperature and humidity in the test chamber (1), a second sub-stand (6.2) with a height- and angle-adjustable second arm (7.2) for placing a sensor (9c) for temperature of the test liquid (4), wherein the second arm (7.2) is immersed in the test liquid (4), and a third sub-stand (6.3) with a height- and angle-adjustable third arm (7.3) for positioning an optical device (10), wherein a carrier for fixing the tested sample (8) is formed by a height- and angle-adjustable fourth arm (7.1b) on the first sub-stand (6.1), on which the tested sample (8) and the sensor (9b) for temperature on the tested sample (8) are mounted.

8. Device according to any one of claims 1 to 7 **characterized in that** the test liquid (4) is from the group consisting of either distilled water, Na₂SO₄ solution or NaCl solution.

9. Device according to any one of claims 1 to 8, **characterized in that** there is a deflector having a surface area greater than the surface area of the tested sample (8) is disposed in the space above the tested sample (8) and the deflector has an inclination relative to the level of the test liquid (4) of between 3° and 80°.

10. Device according to claim 9, **characterized in that** the deflector is formed directly by the sealable lid (2) of the test chamber (1).

11. Device according to claim 9 or 10, **characterized in that** the deflector is formed by an auxiliary plane (16) located between the sealable lid (2) of the test chamber (1) and the tested sample (8).

12. Device according to claim 11, **characterized in that** the auxiliary plane (16) is attached by its ends to the inner shell of the test chamber (1).

13. Device according to claim 11 or 12, **characterized in that** the auxiliary plane (16) is suspended by cables (18) in the space of the test chamber (1).

14. Device according to any one of claims 11 to 13, **characterized in that** the tested sample (8) is placed in the test chamber (1) on the first stand (6.1) on the height and angle adjustable fourth arm (7.1b) and the auxiliary plane (16) is placed between the sealable lid (2) and the tested sample (8) on an auxiliary arm.

15. Device according to any one of claims 11 to 14, **characterized in that** the auxiliary plane (16) is arranged on a separate stand and is adjusted in height and angle.

16. Device according to any one of claims 9 to 15, **characterized in that** the deflector is provided with a hydrophilic fabric (17) which is fixed on the side facing the tested sample (8) and/or is provided with a heating element.

## Patentansprüche

1. Vorrichtung zur Prüfung der elektrochemischen Migration, umfassend
- eine Prüfkammer (1) zur Aufnahme einer zu prüfenden Probe (8) und
- eine Prüfflüssigkeit (4),
wobei die Prüfflüssigkeit (4) im Inneren am Boden der Prüfkammer (1) angeordnet ist,
wobei die Prüfkammer (1) mit einem Deckel (2) verschließbar ist,
die Vorrichtung mit einem Stromversorgungskabel (8.1) zur Verbindung der zu prüfenden Probe (8) mit einer Spannungsquelle (11) versehen ist,
**dadurch gekennzeichnet, dass**
in ihrer Nähe zu deren Erwärmung eine regelbare Heizeinrichtung (5) angeordnet ist und
oberhalb des Flüssigkeitsspiegels der Prüfflüssigkeit (4) im Innenraum der Prüfkammer (1) ein höhen- und winkelverstellbarer Träger für die zu prüfende Probe (8) angeordnet ist-

2. Vorrichtung nach Anspruch 1, **dadurch gekennzeichnet, dass** die regelbare Heizeinrichtung (5) direkt oder über einen Temperaturregler (14) bidirektional mit einer Steuer- und Auswerteeinheit (13) verbunden ist, die mit Software zur Überwachung und Auswertung der Temperatur- und Feuchtigkeitsparameter ausgestattet ist und bidirektional mit einer Messeinrichtung (12) verbunden ist, und wobei die Spannungsquelle (11) bidirektional mit der Steuer- und Auswerteeinheit (13) verbunden ist, wobei die Vorrichtung mit mindestens einem Sensor (9c) für die Temperatur der Prüfflüssigkeit (4) und/oder mindestens einem Sensor (9b) für die Temperatur an der zu prüfenden Probe (8) und/oder mindestens einem Sensor (9a) für die Temperatur und Feuchtigkeit im Innenraum der Prüfkammer (1) ausgestattet ist, wobei das Kabel (8.2) zur Verbindung der Messeinrichtung (12) mit der zu prüfenden Probe (8) sowie die bidirektional mit der Steuer- und Auswerteeinheit (13) verbundenen Kabel, nämlich das Kabel (9.1a) des Sensors (9a) für die Temperatur und Feuchtigkeit im Innenraum der Prüfkammer (1), das Kabel (9.1b) des Sensors (9b) für die Temperatur an der zu prüfenden Probe (8) und das Kabel (9.1c) des Sensors (9c) für die Temperatur der Prüfflüssigkeit (4), über mindestens eine Durchführung (3a) aus der Prüfkammer (1) herausgeführt sind und die Prüfkammer (1) mit einer verschließbaren Öffnung (3b) zum Einsetzen und Entnehmen der zu prüfenden Probe (8) versehen ist.

3. Vorrichtung nach Anspruch 2, **dadurch gekennzeichnet, dass** die Durchführung (3a) und die Öffnung (3b) zum Einsetzen und Entnehmen der zu prüfenden Probe (8) hermetisch verschlossen sind.

4. Vorrichtung nach Anspruch 2 oder 3, **dadurch gekennzeichnet, dass** die Öffnung (3b) zum Einsetzen und Entnehmen der zu prüfenden Probe (8) im Deckel (2) und/oder im Körper der Prüfkammer (1) ausgebildet ist.

5. Vorrichtung nach einem der Ansprüche 2 bis 4**, dadurch gekennzeichnet, dass** mindestens eine Durchführung (3a) in dem verschließbaren Deckel (2) und/oder im Körper der Prüfkammer (1) ausgebildet ist.

6. Vorrichtung nach einem der Ansprüche 1 bis 5**, dadurch gekennzeichnet, dass** im Sichtfeld der zu prüfenden Probe (8) eine optische Einrichtung (10) angeordnet ist, die über ein bidirektionales Kabel (10.1), das bidirektional mit der Steuer- und Auswerteeinheit (13) verbunden ist, aus der Prüfkammer (1) herausgeführt ist.

7. Vorrichtung nach einem der Ansprüche 1 bis 6**, dadurch gekennzeichnet, dass** am Boden der Prüfkammer (1) ein Gestell (6) angeordnet ist, das mit einer ersten Stütze (6.1) mit einem höhen- und winkelverstellbaren ersten Arm (7.1a) zur Anordnung des Sensors (9a) für die Temperatur und Feuchtigkeit im Innenraum der Prüfkammer (1), einer zweiten Stütze (6.2) mit einem höhen- und winkelverstellbaren zweiten Arm (7.2) zur Anordnung des Sensors (9c) für die Temperatur der Prüfflüssigkeit (4), wobei dieser zweite Arm (7.2) in die Prüfflüssigkeit (4) eingetaucht ist, und einer dritten Stütze (6.3) mit einem höhen- und winkelverstellbaren dritten Arm (7.3) zur Anordnung der optischen Einrichtung (10) versehen ist, wobei der Träger zur Fixierung der zu prüfenden Probe (8) durch einen höhen- und winkelverstellbaren vierten Arm (7.1b) an der ersten Stütze (6.1) gebildet ist, an dem die zu prüfende Probe (8) und der Sensor (9b) für die Temperatur an der zu prüfenden Probe (8) befestigt sind.

8. Vorrichtung nach einem der Ansprüche 1 bis 7**, dadurch gekennzeichnet, dass** die Prüfflüssigkeit (4) aus der Gruppe bestehend aus destilliertem Wasser, einer Na₂SO₄-Lösung und einer NaCl-Lösung ausgewählt ist.

9. Vorrichtung nach einem der Ansprüche 1 bis 8**, dadurch gekennzeichnet, dass** im Raum oberhalb der zu prüfenden Probe (8) ein Deflektor angeordnet ist, dessen Fläche größer als die Fläche der zu prüfenden Probe (8) ist und der Deflektor gegenüber dem Flüssigkeitsspiegel der Prüfflüssigkeit (4) eine Neigung im Bereich von 3° bis 80° aufweist.

10. Vorrichtung nach Anspruch 9**, dadurch gekennzeichnet, dass** der Deflektor unmittelbar durch den verschließbaren Deckel (2) der Prüfkammer (1) gebildet ist.

11. Vorrichtung nach Anspruch 9 oder 10**, dadurch gekennzeichnet, dass** der Deflektor durch eine Hilfsebene (16) gebildet ist, die zwischen dem oberen Deckel (2) der Prüfkammer (1) und der zu prüfenden Probe (8) angeordnet ist.

12. Vorrichtung nach Anspruch 11**, dadurch gekennzeichnet, dass** die Hilfsebene (16) mit ihren Enden an der Innenwand der Prüfkammer (1) befestigt ist.

13. Vorrichtung nach Anspruch 11 oder 12**, dadurch gekennzeichnet, dass** die Hilfsebene (16) im Innenraum der Prüfkammer (1) an Seilen (18) aufgehängt ist.

14. Vorrichtung nach einem der Ansprüche 11 bis 13**, dadurch gekennzeichnet, dass** die zu prüfende Probe (8) in der Prüfkammer (1) an der ersten Stütze (6.1) auf dem höhen- und winkelverstellbaren vierten Arm (7.1b) angeordnet ist und die Hilfsebene (16) zwischen dem oberen Deckel 2 und der zu prüfenden Probe (8) an einem Hilfsarm angeordnet ist.

15. Vorrichtung nach einem der Ansprüche 11 bis 14**, dadurch gekennzeichnet, dass** die Hilfsebene (16) an einer separaten Stütze angeordnet und höhen- und winkelverstellbar ist.

16. Vorrichtung nach einem der Ansprüche 9 bis 15**, dadurch gekennzeichnet, dass** der Deflektor mit einem hydrophilen Textilmaterial (17) versehen ist, das auf der der zu prüfenden Probe (8) zugewandten Seite befestigt ist, und/oder mit einem Heizelement versehen ist.

## Revendications

1. Équipement d'essai de la migration électrochimique contenant
- une chambre d'essai (1) pour placer l'échantillon à tester (8) et
- un liquide d'essai (4),
le liquide d'essai (4) étant situé à l'intérieur près du fond de la chambre d'essai (1),
la chambre d'essai (1) pouvant être fermée par un couvercle (2),
l'équipement est muni d'un câble d'alimentation (8.1) pour connecter l'échantillon à tester (8) à la source de tension (11),
**caractérisé en ce que**
à proximité de celle-ci, un dispositif de chauffage réglable (5) est disposé destiné à son chauffage et
au-dessus du niveau du liquide d'essai (4), dans l'espace de la chambre d'essai (1), un support réglable en hauteur et en angle de l'échantillon à tester (8) est placé

2. Équipement selon la revendication 1, **caractérisé en ce que** le dispositif de chauffage réglable (5) est connecté bidirectionnellement, directement ou via un régulateur de température (14), à une unité de commande et d'évaluation (13) équipée d'un logiciel de surveillance et d'évaluation des paramètres de température et d'humidité, qui est connectée bidirectionnellement à un dispositif de mesure (12), et où, la source de tension (11) est connectée bidirectionnellement à l'unité de commande et d'évaluation (13), l'équipement étant équipé d'au moins un capteur (9c) de température du liquide d'essai (4) et/ou d'au moins un capteur (9b) de température de l'échantillon à tester (8) et/ou d'au moins un capteur (9a) de température et d'humidité de la chambre d'essai (1), où le câble (8.2) pour connecter le dispositif de mesure (12) à l'échantillon à tester (8) ainsi que les câbles connectés bidirectionnellement à l'unité de commande et d'évaluation (13), à savoir le câble (9.1a) du capteur (9a) de température et d'humidité de la chambre d'essai (1), le câble (9.1b) du capteur de température. (9b) de l'échantillon à tester (8) et le câble (9.1c) du capteur de température (9c) du liquide d'essai (4) sont conduits hors de la chambre d'essai (1) à travers au moins un passage (3a) et la chambre d'essai (1) est munie d'une ouverture pouvant être fermée (3b) pour insérer et retirer l'échantillon à tester (8).

3. Équipement selon la revendication 2, **caractérisé en ce que** le passage (3a) et l'ouverture (3b) pour insérer et retirer l'échantillon à tester (8) sont hermétiquement fermés.

4. Équipement selon la revendication 2 ou 3, **caractérisé en ce que** l'ouverture (3b) pour insérer et retirer l'échantillon d'essai (8) est formée dans le couvercle pouvant être fermé (2) et/ou dans le corps de la chambre d'essai (1).

5. Équipement selon l'une quelconque des revendications 2 à 4, **caractérisé en ce qu'**au moins un passage (3a) est formé dans le couvercle pouvant être fermé (2) et/ou dans le corps de la chambre d'essai (1).

6. Équipement selon l'une quelconque des revendications 1 à 5, **caractérisé en ce qu'**un dispositif optique (10) est disposé dans le champ de vision de l'échantillon à tester (8), qui est conduit hors de la chambre d'essai (1) par un câble double face (10.1) connecté de manière bidirectionnelle à l'unité de commande et d'évaluation (13).

7. Équipement selon l'une quelconque des revendications 1 à 6, **caractérisé en ce qu'**un bâti (6) est placé au fond de la chambre d'essai (1) et est muni d'un premier montant (6.1) doté d'un premier bras (7.1a) réglable en hauteur et en angle, destiné à recevoir un capteur (9a) de température et d'humidité de l'espace de la chambre d'essai (1), d'un deuxième montant (6.2) doté d'un deuxième bras (7.2) réglable en hauteur et en angle, destiné à recevoir un capteur (9c) de température du liquide d'essai (4), ce deuxième bras (7.2) étant immergé dans le liquide d'essai (4), et d'un troisième montant (6.3) doté d'un troisième bras (7.3) réglable en hauteur et en angle, destiné à recevoir un dispositif optique (10), le support pour fixer l'échantillon à tester (8) étant formé par un quatrième bras (7.1b) réglable en hauteur et en angle se trouvant sur le premier montant (6.1), sur lequel sont placés l'échantillon à tester (8) et le capteur de température (9b) de l'échantillon à tester (8).

8. Équipement selon l'une quelconque des revendications 1 à 7, **caractérisé en ce que** le liquide d'essai (4) appartient au groupe constitué d'eau distillée, de solution de Na ₂ SO ₄ et de solution de NaCl.

9. Équipement selon l'une quelconque des revendications 1 à 8, **caractérisé en ce qu'**un déflecteur est placé dans l'espace au-dessus de l'échantillon à tester (8), dont la surface est plus grande que la surface de l'échantillon à tester (8) et le déflecteur a une inclinaison comprise entre 3° et 80° par rapport au niveau du liquide d'essai (4).

10. Équipement selon la revendication 9, **caractérisé en ce que** le déflecteur est composé par un couvercle (2) de la chambre d'essai (1) pouvant être fermé directement .

11. Équipement selon la revendication 9 ou 10, **caractérisé en ce que** le déflecteur est composé par un plan auxiliaire (16) situé entre le couvercle supérieur (2) de la chambre d'essai (1) et l'échantillon à tester (8).

12. Équipement selon la revendication 11, **caractérisé en ce que** le plan auxiliaire (16) est fixé par ses extrémités à la coque intérieure de la chambre d'essai (1).

13. Équipement selon la revendication 11 ou 12, **caractérisé en ce que** le plan auxiliaire (16) est suspendu à des câbles (18) dans l'espace de la chambre d'essai (1).

14. Équipement selon l'une quelconque des revendications 11 à 13, **caractérisé en ce que** l'échantillon à tester (8) est placé dans la chambre d'essai (1) sur le premier montant (6.1) sur un quatrième bras réglable en hauteur et en angle (7.1b) et le plan auxiliaire (16) est située entre le couvercle supérieur 2 et l'échantillon à tester (8) sur le bras auxiliaire.

15. Équipement selon l'une quelconque des revendications 11 à 14, **caractérisé en ce que** le plan auxiliaire (16) est située sur un montant séparé et est réglable en hauteur et en angle.

16. Équipement selon l'une quelconque des revendications 9 à 15 **, caractérisé en ce que** le déflecteur est muni d'un textile hydrophile (17) qui est fixé du côté faisant face à l'échantillon à tester (8) et/ou est muni d'un élément chauffant.
